# EUROPEAN PATENT APPLICATION

(11) **EP 4 847 472 A1**
(43) Date of publication of application: **02.12.2026**
(21) Application number: 25744878.7
(22) Date of filing: 10.01.2025
(51) Int. Cl.: C04B 35/587, H01L 23/36, H01L 23/373, H05K 1/03

(54) **SILICON NITRIDE SINTERED BODY AND SILICON NITRIDE HEAT DISSIPATION SUBSTRATE**

(30) Priority: 25.01.2024 JP 2024009504
(71) Applicant: Niterra Co., Ltd., Nagoya-shi, Aichi 461-0005 (JP)
(72) Inventor: MOTEKI, Jun, Nagoya-shi, Aichi 461-0005 (JP); IHARA, Akio, Nagoya-shi, Aichi 461-0005 (JP); IKAI, Yoshihito, Nagoya-shi, Aichi 461-0005 (JP); MITSUOKA, Takeshi, Nagoya-shi, Aichi 461-0005 (JP)
(74) Representative: Grünecker Patent- und Rechtsanwälte PartG mbB
(86) International application number: PCT/JP2025/000721
(87) International publication number: WO 2025/158946

(57) **Abstract**

To provide a silicon nitride-based sintered body and a silicon nitride-based heat radiation substrate having high mechanical strength, while high thermal conductivity is maintained. The silicon nitride-based sintered body mainly includes silicon nitride-based grains and a grain boundary phase surrounding the silicon nitride-based grains. The silicon nitride-based sintered body at least contains a rare earth element in a total amount of 1.0 to 6.5 wt% and an alkali/alkaline earth metal element in a total amount of 0.3 to 3.0 wt%. The average value of element ratio Re/(A+Re) at the grain boundary between two of the silicon nitride-based grains is 0.1 to 0.5, wherein Re represents an element amount of the rare earth element, and A represents an element amount of the alkali/alkaline earth metal element.

## Description

### TECHNICAL FIELD

The present invention relates to a silicon nitride-based sintered body and to a silicon nitride-based heat radiation substrate.

### BACKGROUND ART

Silicon nitride, having high thermal conductivity and mechanical strength, attracts attention as a material for electrically insulating heat radiation substrates of power modules for inverters installed in electric vehicles (EVs) and hybrid vehicles (HVs). Conventionally, aluminum nitride has been widely used as a material of electrically insulating heat radiation substrates. However, in the case of a power module for large current such as that for EVs, the temperature of the power module rises to about 250°C, and a large thermal stress is generated in its substrate due to the difference in thermal expansion between the substrate and a metal such as copper bonded thereto. As a result, the substrate formed of aluminum nitride having low mechanical strength is cracked or broken. Therefore, silicon nitride, which among general insulating ceramic materials is high in thermal conductivity and has higher mechanical strength, has been employed in an increasing number of cases, although the thermal conductivity of silicon nitride is lower than that of aluminum nitride.

Patent Document 1 discloses a silicon nitride sintered body including a plurality of silicon nitride grains and having a grain boundary triple point which is located at a site defined by three or more of the silicon nitride grains. The grain boundary triple point contains Mg and at least one element RE selected from rare earth elements. The ratio of Mg to RE (Mg/RE) at the grain boundary triple point satisfies Mg/RE≤1. The O content of the silicon nitride grains is 0.05 mass% or less.

### PRIOR ART DOCUMENTS

### PATENT DOCUMENTS

Patent Document 1: JP2022-153934A

### SUMMARY OF THE INVENTION

### PROBLEM TO BE SOLVED BY THE INVENTION

In recent years, the current flowing through an inverter has increased year by year. Thus, a considerably large thermal stress is applied to a silicon nitride substrate, resulting in cracking of the substrate and other problems. The flexural strength of the silicon nitride sintered body disclosed in Patent Document 1 is about 500 MPa. When such a silicon nitride substrate is used under higher temperature conditions as compared with conventional conditions, cracking and the like more frequently occur by thermal stress due to poor mechanical strength.

In consideration of the drawbacks, when a silicon nitride sintered body is employed as an electrically insulating heat radiation substrate of a power device, demand has arisen for further enhancement in mechanical strength so as to further ensure reliability of the substrate, while high thermal conductivity is maintained.

The present invention has been conceived under such circumstances, and an object of the invention is to provide a silicon nitride-based sintered body and a silicon nitride-based heat radiation substrate having high mechanical strength, while high thermal conductivity is maintained.

### MEANS FOR SOLVING THE PROBLEMS

(1) In order to attain the aforementioned object, the present invention provides a silicon nitride-based sintered body with the following technical means. Accordingly, an application example of the silicon nitride-based sintered body of the present invention is directed to a silicon nitride-based sintered body mainly comprising silicon nitride-based grains and a grain boundary phase surrounding the silicon nitride-based grains, wherein the silicon nitride-based sintered body at least contains a rare earth element in a total amount of 1.0 to 6.5 wt% and an alkali/alkaline earth metal element in a total amount of 0.3 to 3.0 wt%, and an average value of element ratio Re/(A+Re) at the grain boundary between two of the silicon nitride-based grains is 0.1 to 0.5, wherein Re represents an element amount of the rare earth element, and A represents an element amount of the alkali/alkaline earth metal element.
(2) In the silicon nitride-based sintered body according to the application example (1) above, the alkali/alkaline earth metal element contains one or more elements selected from Mg and Ca, and the rare earth element contains one or more elements selected from Y, La, and Yb.
(3) The silicon nitride-based sintered body according to the application example (1) or (2) above further contains a group 4 element. At least a part of the group 4 element forms one or more compounds each containing nitrogen or carbon.
(4) An application example of the silicon nitride-based heat radiation substrate of the present invention is characterized by being formed of the silicon nitride-based sintered body according to any of (1) to (3) above.
(5) The silicon nitride-based heat radiation substrate according to the application example (4) above has a flexural strength of 700 MPa or higher.
(6) The silicon nitride-based heat radiation substrate according to the application example (4) or (5) above has a thermal conductivity of 85 W/mK or higher.
(7) The silicon nitride-based heat radiation substrate according to any of the application examples (4) to (6) above has a thickness in a direction perpendicular to its one main face of 220 µm or more and 690 µm or less.

### EFFECTS OF THE INVENTION

According to the silicon nitride-based sintered body or the silicon nitride-based heat radiation substrate of the present invention, there can be provided a silicon nitride-based sintered body or a silicon nitride-based heat radiation substrate which achieves higher mechanical strength, while high thermal conductivity is maintained.

### BRIEF DESCRIPTION OF THE DRAWINGS

[FIG. 1] FIG. 1 is a schematic perspective view showing an example of a silicon nitride-based heat radiation substrate according to an embodiment of the present invention.
[FIG. 2] FIG. 2 is a schematic cross-sectional view showing an example of a power device employing the silicon nitride-based heat radiation substrate according to an embodiment of the present invention.
[FIG. 3] FIG. 3 is a table showing element contents and characteristics of the grain boundary phase of each sample, and characteristics of each sample.
[FIG. 4] FIG. 4(a) is a SEM image of silicon nitride sintered body of sample 1, and FIG. 4(b) is a SEM image of silicon nitride sintered body of sample 10.

### MODES FOR CARRYING OUT THE INVENTION

Embodiments of the present invention will now be described with reference to the drawings. In order to facilitate understanding of description, identical constituent elements in the drawings are denoted by the same reference numerals, and their redundant descriptions are omitted. Notably, in structural views, the sizes of constituent elements are conceptually represented and do not necessarily represent the actual dimensional ratios.

### [Embodiments]

### [Structures of silicon nitride-based sintered body]

Firstly, an embodiment of the silicon nitride-based sintered body of the present invention will be described. The silicon nitride-based sintered body according to the embodiment of the present invention is a silicon nitride-based sintered body mainly comprising silicon nitride-based grains and a grain boundary phase surrounding the silicon nitride-based grains. The term "silicon nitride-based grains" refers to silicon nitride grains or Sialon grains. However, since Sialon provides a lower thermal conductivity as compared with silicon nitride, the amount of Sialon is preferably adjusted to that generated within a range of the below-mentioned Al content as the upper limit. The expression "mainly comprising silicon nitride-based grains and a grain boundary phase surrounding the silicon nitride-based grains" allows presence of an impurity other than the below-mentioned elements of 0.5 wt% or less.

The silicon nitride-based sintered body contains a rare earth element in a total amount of 1.0 to 6.5 wt%. When the rare earth element content is less than the lower limit of the range, sinterability decreases, and pores remain, resulting in a drop in mechanical strength of the silicon nitride-based sintered body in some cases. When the rare earth element content is higher than the upper limit of the range, the amount of the grain boundary phase increases, resulting in a drop in thermal conductivity of the silicon nitride-based sintered body in some cases. Regardless of the species of the rare earth element contained in the silicon nitride-based sintered body, the same effect can be conceivably achieved. The rare earth element preferably includes one or more elements selected from yttrium (Y), lanthanum (La), and ytterbium (Yb).

The silicon nitride-based sintered body contains an alkali/alkaline earth metal element in a total amount of 0.3 to 3.0 wt%. When the alkali/alkaline earth metal element is lower than the lower limit of the range, the mechanical strength of the silicon nitride-based sintered body decreases in some cases. When the alkali metal element content or the alkaline earth metal element content is higher than the upper limit of the range, the thermal conductivity of the silicon nitride-based sintered body decreases in some cases. The term "alkali/alkaline earth metal element" refers to an alkali metal element or an alkaline earth metal element. The alkali/alkaline earth metal element preferably includes one or more elements selected from Mg and Ca.

The silicon nitride-based sintered body has an average value of element ratio Re/(A+Re) at the grain boundary between two of the silicon nitride-based grains of 0.1 to 0.5, wherein Re represents an element amount of the rare earth element, and A represents an element amount of the alkali/alkaline earth metal element. The term "grain boundary between two of the silicon nitride-based grains" refers to a grain boundary between silicon nitride-based grains adjacent to each other. Each of the terms "element amount of the rare earth element Re" and "element amount of the alkali/alkaline earth metal element A" refers to an element amount determined by point analysis of the below-mentioned scanning transmission electron microscope - energy dispersive spectroscopy (STEM-EDS) analysis at any point on the grain boundary between two of the silicon nitride-based grains.

When the value of the ratio Re/(A+Re) falls within the above range, there can be attained both columnar growth of silicon nitride-based grains and filling the grain-boundary pore with the grain boundary phase by virtue of a decrease in viscosity. When the value of the ratio Re/(A+Re) exceeds the upper limit of the aforementioned range; i.e., the Re content of the grain boundary between two of the silicon nitride-based grains increases, the viscosity of the grain boundary component converted to the liquid phase increases, sufficient filling of the pore with the grain boundary phase fails to be achieved, resulting in an increase in unfilled pore. In such a case, a drop in mechanical strength and thermal conductivity may occur in some cases. When the value of the ratio Re/(A+Re) is lower than the lower limit of the aforementioned range; i.e., the Re content of the grain boundary between two of the silicon nitride-based grains decreases, columnar growth of silicon nitride-based grains fails to be promoted, resulting in a drop in mechanical strength and toughness in some cases.

The element ratio Re/(A+Re) at the grain boundary between two of the silicon nitride-based grains may be determined through STEM-EDS analysis. In a specific procedure, a polished surface of the silicon nitride-based sintered body is further processed through ion milling, and five sites in the processed surface are selected at random. A field of view (5 µm × 5 µm) at each site is observed at a magnification of 50,000. Subsequently, one grain boundary between two of the silicon nitride-based grains is selected at random in each of the fields of view at the five sites, and each amount is determined through point analysis. From the thus-determined rare earth element amount Re and the alkali/alkaline earth metal element amount A, the ratio Re/(A+Re) is calculated at each site, to thereby obtain the average (arithmetic mean).

Since the grain boundary phase is provided in the sintered body in a random manner, the ratio Re/(A+Re) calculated from the results of STEM-EDS analysis of an ion-milled surface of the silicon nitride-based sintered body is substantially the same value in any site of the sintered body.

The grain boundary phase preferably includes at least one or more crystal phases among an M phase, a J phase, a monosilicate phase, and a disilicate phase. More preferably, the grain boundary phase includes the M phase. The crystal phase of the grain boundary phase may be identified on the basis of the results of X-ray diffraction (XRD) analysis. The term "M phase" refers to a crystal identified by No. 00-045-0249 in the PDF (powder diffraction file) card. The M phase is also called a melilite phase and assumes a Y₂Si₃O₃N₄-type crystal. The term "J phase" refers to a crystal identified by No. 01-086-1106 in the PDF card. The J phase assumes a Y₄Si₂O₇N₂-type crystal. The term "monosilicate phase" refers to a crystal identified by No. 00-052-181 in the PDF card. The monosilicate phase is also called an m phase and assumes a Y₂SiO₅-type crystal. The term "disilicate phase" refers to a crystal identified by No. 01-072-359 in the PDF card. The disilicate phase is also called a d phase and assumes a Y₂Si₂O₇-type crystal. In each case, a typical composition of the corresponding crystal is shown. However, a constituting element may vary when the crystal system, the space group, and configuration of the constituting elements are the same. For example, the M phase may also be Yb₂Si₃O₃N₄.

The silicon nitride-based sintered body preferably contains a group 4 element. Also preferably, the silicon nitride-based sintered body contains a group 4 element in a total amount of 0.30 to 3.0 wt%. Yet preferably, in the silicon nitride-based sintered body, at least a part of the group 4 element forms one or more compounds, the compounds each containing at least one of nitrogen and carbon.

When the group 4 element content falls within the above range, both high thermal conductivity and high mechanical strength can be attained. Since the group 4 element does not form a solid solution with silicon nitride, a drop in thermal conductivity caused by phonon scattering is not evoked. In addition, the group 4 element does not form a solid solution with a grain boundary phase formed via reaction between the rare earth element and silicon nitride. Thus, the group 4 element alone easily forms a compound, and residual pores are filled with the compound. As a result, the mechanical strength of the silicon nitride-based sintered body is enhanced. In addition, the group 4 element compound particles suppress propagation of cracking, thereby leading to high toughness. Notably, the "group 4 element compound" may also encompass a compound containing only a group 4 element and nitrogen or carbon; a compound containing a group 4 element, nitrogen, and carbon; and such a compound forming a solid solution with another group 4 element or an anion (e.g., oxygen), so long as the intrinsic crystal structure is stable. The group 4 element compound can be identified through results of X-ray diffraction (XRD) analysis.

The group 4 element preferably contains one or more elements selected from zirconium (Zr) and hafnium (Hf). In this case, more specific formulation of the group 4 element compound can be achieved. When the silicon nitride-based sintered body contains Zr, zirconium nitride (ZrN), zirconium carbide (ZrC), and zirconium carbide nitride (ZrCN) are easily formed as the group 4 element compound. When the silicon nitride-based sintered body contains Hf, hafnium nitride (HfN), hafnium carbide (HfC), and hafnium carbide nitride (HfCN) are easily formed as the group 4 element compound.

The silicon nitride-based sintered body may contain Al in an amount more than 0 wt% and 0.1 wt% or less. Al is an impurity originating from a raw material, and incorporation of Al improves sinterability of the silicon nitride-based sintered body, thereby increasing the mechanical strength of the silicon nitride-based sintered body. Also, when the Al content falls within the range, a drop in thermal conductivity caused by formation of Sialon is suppressed to a substantially negligible level. When the Al content is in excess of 0.1 wt%, the Sialon content of the silicon nitride-based sintered body increases, and the thermal conductivity of the silicon nitride-based sintered body may decrease in some cases.

By virtue of the aforementioned technical features, the silicon nitride-based sintered body can exhibit higher mechanical strength, while high thermal conductivity is maintained.

### [Configuration of silicon nitride-based heat radiation substrate]

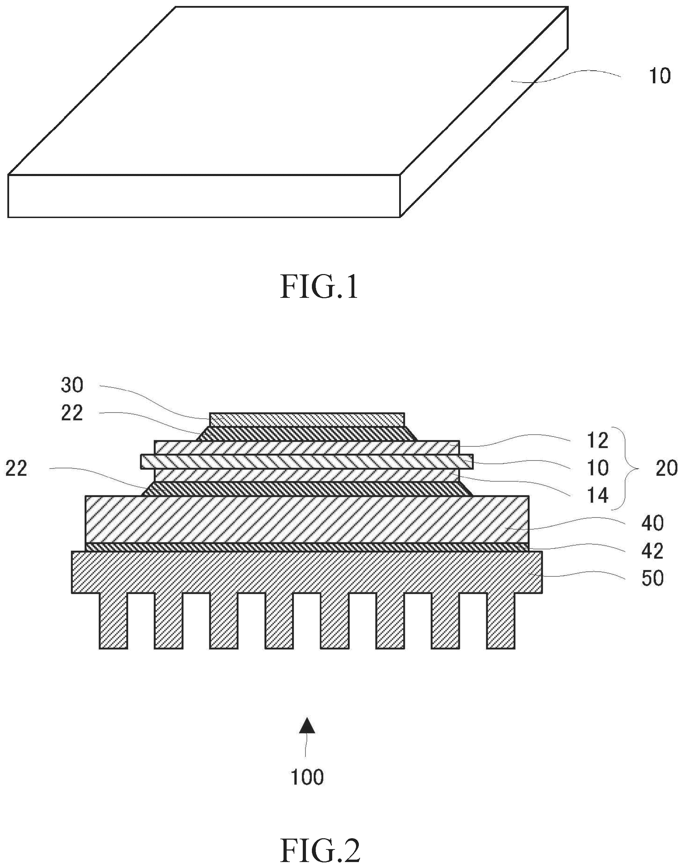

FIG. 1 is a schematic perspective view showing an example of a silicon nitride-based heat radiation substrate according to an embodiment of the present invention. A silicon nitride-based heat radiation substrate 10 according to the present invention is formed of the aforementioned silicon nitride-based sintered body. Thus, high mechanical strength can be achieved, while high thermal conductivity is maintained. As a result, occurrence of any failure in a circuit substrate employing the heat radiation substrate can be reduced. The silicon nitride-based heat radiation substrate 10 of the present invention can be suitably used as a heat radiation substrate of a circuit substrate for power devices. The silicon nitride-based heat radiation substrate 10 is shaped into, for example, a plate.

The silicon nitride-based heat radiation substrate 10 preferably has a flexural strength of 700 MPa or higher. In this case, breaking of the silicon nitride-based heat radiation substrate 10 can be suppressed.

The flexural strength can be measured through the following procedure. Specifically, in accordance with ISO 23242, a silicon nitride-based heat radiation substrate is processed to specific dimensions of (fixed thickness) × 12 × 25 mm. Then, flexural strength is measured with a span of 15 mm in a three-point bending method. ISO 23242 may be applied to a ceramic thin plate having a thickness of 0.2 mm to 1.0 mm.

Preferably, the silicon nitride-based heat radiation substrate 10 has a thermal conductivity of 85 W/mK or higher. In this case, the performance as a heat radiation substrate can be fully achieved.

Thermal conductivity may be measured and calculated through the following procedure. Firstly, a silicon nitride-based heat radiation substrate 10 is processed into pieces having dimensions of 0.32 mm × 10 mm × 10 mm. Thermal diffusivity of each piece is measured through a xenon flash method. Also, the density of the silicon nitride-based heat radiation substrate 10 is measured in accordance with a method according to JIS R1634. Specific heat is fixed at a constant value of 0.68 cm²/sec. From the thus-obtained thermal diffusivity and density, thermal conductivity can be calculated by an equation: (thermal conductivity)=(density)×(specific heat)×(thermal diffusivity).

Preferably, the silicon nitride-based heat radiation substrate 10 has a thickness in a direction perpendicular to its one main face of 220 µm or more and 690 µm or less. In this case, the mechanical strength and heat radiation performance of the silicon nitride-based heat radiation substrate 10 can be achieved in a well-balanced manner. When the thickness is less than the lower limit of the range, the mechanical strength of the substrate decreases in some cases, whereas the thickness is greater than the upper limit of the range, heat radiation performance decreases in some cases.

### [Configuration of power device]

FIG. 2 is a schematic cross-sectional view showing an example of a power device employing the silicon nitride-based heat radiation substrate according to an embodiment of the present invention. A power device 100 has a circuit substrate 20, a power semiconductor 30, a heat radiation plate 40, and a heat radiation member 50.

The circuit substrate 20 has a circuit layer 12 formed on one main face of the silicon nitride-based heat radiation substrate 10, and a conductor layer 14 formed on the face opposing to the one main face. The circuit layer 12 and the conductor layer 14 are preferably formed of a metal, more preferably a metal mainly containing copper. The circuit layer 12 and the conductor layer 14 are joined directly to the silicon nitride-based heat radiation substrate 10 or by the mediation of a joining material such as braze.

On the circuit layer 12 of the circuit substrate 20, a power semiconductor 30 is mounted. The power semiconductor 30 and the circuit layer 12 may be joined together by use of a solder 22 or the like. The power semiconductor 30 may be formed of, for example, a semiconductor which allows passage of large current for EVs and is easily heated to high temperature. Since the silicon nitride-based heat radiation substrate 10 of the present invention exhibits high mechanical strength while high thermal conductivity is maintained, generation of cracking or the like is prevented, even when large thermal stress is generated in the silicon nitride-based heat radiation substrate 10 due to the high temperature-induced difference in thermal expansion between the silicon nitride-based heat radiation substrate 10 and the joining metal.

To the lower face of the conductor layer 14 of the circuit substrate 20, a heat radiation plate 40 is joined. The heat radiation plate 40 and the conductor layer 14 may be bonded together by use of a solder 22 or the like. The face opposite to the face joined to the conductor layer 14 of the heat radiation plate 40 is in contact with a heat radiation member 50 via a grease 42. The heat radiation plate 40 is preferably formed of a metal, more preferably a metal mainly containing copper. The heat radiation member 50 is provided with heat radiation fins. The heat radiation member 50 is preferably formed of a metal, more preferably a metal mainly containing copper or aluminum.

### [Method of manufacturing silicon nitride-based sintered body and silicon nitride-based heat radiation substrate]

An example of a method of manufacturing the silicon nitride-based sintered body and the silicon nitride-based heat radiation substrate will be described. Firstly, essential members are selected from the powder raw materials of the silicon nitride-based sintered body, and weighed to attain the target composition. The powder raw materials of the silicon nitride-based sintered body may be an oxide, a carbonate salt, a hydroxide, a nitride, etc. of the elements contained in the silicon nitride-based sintered body. In addition to silicon nitride (Si₃N₄), examples of the powder raw material of the silicon nitride-based sintered body include magnesium carbonate (MgCO₃), calcium carbonate (CaCO₃), yttrium oxide (Y₂O₃), ytterbium oxide (Yb₂O₃), lanthanum oxide (La₂O₃), and zirconium nitride (ZrN).

Ethanol is added to the powder raw materials, and the mixture is wet-pulverized by means of a ball mill for, for example, 6 to 60 hours, to thereby yield a slurry. The slurry is dried by heating on a hot water bath or by means of a spray dryer or the like, to thereby prepare a powder mixture. In an alternative procedure, a binder (e.g., an acrylic binder) is added to the thus-obtained mixed slurry, and mixing is conducted for about 30 minutes, followed by drying.

Subsequently, the powder mixture is charged into a mold and shaped through monoaxial pressing at a pressure of, for example, 100 MPa, to thereby yield a compact of desired shape. Alternatively, the compact may be obtained through a CIP treatment (cold isostatic pressing). The thus-obtained compact is maintained at 600°C for 5 hours in a flow of air, for example. Through the heat treatment (debindering), a debindered body is yielded.

Thereafter, the debindered body was placed in, for example, a carbon mold having an inside coating of BN. The contents of the mold were maintained for firing, for example, at a maximum temperature of 1,900°C for 8 hours in a nitrogen atmosphere at 9 atm. Through firing of the debindered body placed in the carbon mold, the reducing atmosphere is reinforced, and volatilization of an alkali/alkaline earth metal element added as the oxide is facilitated. By volatilizing the alkali/alkaline earth metal element, the relative amount of the rare earth element at the grain boundary increases, to thereby promote columnar growth of the silicon nitride-based grains. Also, when volatilization of the alkali/alkaline earth metal element proceeds to a certain extent, the viscosity of the liquefied grain boundary phase decreases, and pores are filled with the liquefied grain boundary phase while volatilization of the alkali/alkaline earth metal element is less likely to proceed. As a result, the mechanical strength of the silicon nitride-based sintered body is considered to increase. Through the aforementioned procedure, the silicon nitride-based sintered body is yielded.

In the case where the silicon nitride-based sintered body is employed as a silicon nitride-based heat radiation substrate, the sintered body is processed so as to provide a predetermined outer shape having a specific thickness. Examples of the processing which may be employed include cutting, grinding, and blasting.

Through the aforementioned manufacturing method, there can be produced a silicon nitride-based sintered body or a silicon nitride-based heat radiation substrate which exhibits higher mechanical strength, while high thermal conductivity is maintained.

### [Examples and Comparative Examples]

### (Sample 1)

Silicon nitride powder (average particle size: 1.4 µm) in amount of 96.5 wt%, yttrium oxide powder (average particle size: 1.0 µm) in amount of 2.0 wt%, and magnesium carbonate powder (average particle size: 2.5 µm) in amount of 1.5 wt% were weighed. Next, the weighed powder raw materials were subjected to ball milling, to thereby prepare a mixed slurry. In ball milling, the powder raw materials and ethanol were put into a resin pot, and the mixture was pulverized by means of YSZ (i.e., Y₂O₃-partially stabilized zirconia) balls at 60 rpm for 20 hours. To the thus-obtained mixed slurry, a binder (an acrylic binder) was added, and mixing was further conducted for 30 minutes. The resultant slurry was dried through spray drying, to thereby yield a powder mixture.

Subsequently, the obtained powder mixture was press-molded through mono-axially pressing, to thereby form a compact. In a specific procedure, firstly, the powder mixture was charged into a specialized mold and then, the powder mixture was molded through mono-axial pressing at 100 MPa. Then, the thus-obtained compact was debindered. Debindering was conducted by maintaining the compact in a flow of air at a maximum temperature of 600°C for 5 hours. Next, the debindered body was fired. In firing, the compact was maintained in an atmosphere of nitrogen (gas pressure: 9 atm) at a maximum temperature of 1,900°C for 8 hours. The mold employed in firing was a carbon mold having an inside coating of BN. Thus, a silicon nitride-based sintered body of sample 1 was produced.

### (Sample 2)

A silicon nitride-based sintered body of sample 2 was produced under the same conditions as sample 1, except that the amount of yttrium oxide powder was 3.0 wt%.

### (Sample 3)

A silicon nitride-based sintered body of sample 3 was produced under the same conditions as sample 1, except that the amount of yttrium oxide powder was 8.0 wt%.

### (Sample 4)

A silicon nitride-based sintered body of sample 4 was produced under the same conditions as sample 1, except that the amount of yttrium oxide powder was 3.0 wt%, the amount of magnesium carbonate powder was 1.0 wt%, and calcium carbonate powder (average particle size: 2.5 µm) was further added in an amount of 0.5 wt.%.

### (Sample 5)

A silicon nitride-based sintered body of sample 5 was produced under the same conditions as sample 1, except that the amount of yttrium oxide powder was 3.0 wt%, and the amount of magnesium carbonate powder was 5.0 wt%.

### (Sample 6)

A silicon nitride-based sintered body of sample 6 was produced under the same condition as sample 2, except that yttrium oxide powder was changed to ytterbium oxide powder (average particle size: 1.2 µm).

### (Sample 7)

A silicon nitride-based sintered body of sample 7 was produced under the same conditions as sample 2, except that yttrium oxide powder was changed to lanthanum oxide powder (average particle size: 1.0 µm).

### (Sample 8)

A silicon nitride-based sintered body of sample 8 was produced under the same conditions as sample 2, except that the debindered body was fired in a carbon mold with a BN inner coating to which carbon powder had been added.

### (Sample 9)

A silicon nitride-based sintered body of sample 9 was produced under the same conditions as sample 2, except that the balls employed in preparing a mixed slurry were changed from YSZ balls to silicon nitride balls.

### (Sample 10)

A silicon nitride-based sintered body of sample 10 was produced under the same conditions as sample 2, except that the debindered body was fired in a SiC mold with a BN inner coating.

### (Sample 11)

A silicon nitride-based sintered body of sample 11 was produced under the same conditions as sample 2, except that the debindered body was fired in a hBN (hexagonal boron nitride) mold with a BN inner coating.

### [Measurements]

Each obtained sample of the sintered bodies was evaluated by the following measurements after removing a surface portion from the fired surface to a depth of 0.25 mm or more through grinding.

### (Measurement of density)

The density of the sintered body of each sample was measured in accordance with JIS R1634.

### (Determination of element amount)

Through X-ray fluorescence (XRF) analysis of the polished surface obtained, the species and relative amounts of the elements forming each sintered body sample were determined.

### (Identification of constitutional phase)

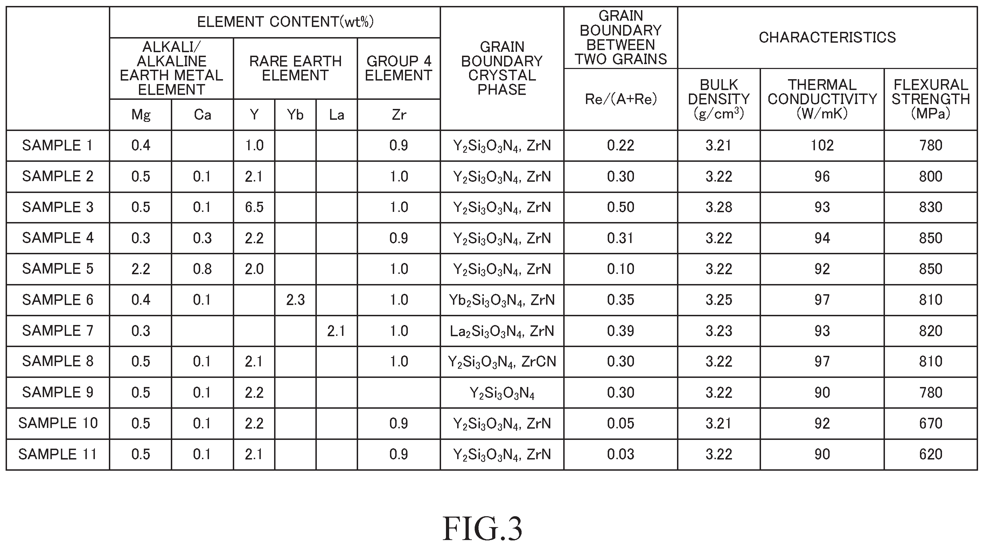

Through XRD analysis, the crystal phase in the grain boundary phase of each sample of a sintered body was identified. However, in the tables of FIG 3, only components identified as crystalline components are shown, and information on the presence of amorphous components is omitted.

### (Measurement of element ratio at grain boundary between two of the silicon nitride-based grains)

The polished surface was further ion-milled. Five points in the milled surface were selected at random and subjected to STEM-EDS analysis. From the results of analysis, the ratio Re/(A+Re) and an average value thereof were determined.

### (Calculation of thermal conductivity)

A sintered body of each sample was processed into pieces having dimensions of 0.32 mm × 10 mm × 10 mm. Thermal diffusivity of each piece was measured using a xenon flash method. The specific heat was fixed at a constant value of 0.68 cm²/sec. From the thermal diffusivity obtained through the xenon flash method and density, thermal conductivity was calculated according to the equation: (thermal conductivity)=(density)×(specific heat)×(thermal diffusivity).

### (Measurement of flexural strength)

In accordance with ISO 23242, a sintered body of each sample was processed to dimensions of 0.32 (thickness) × 12 × 25 mm. Then, the flexural strength was measured with a span of 15 mm by a three-point bending method.

### (Results)

FIG. 3 is a table showing element contents, characteristics of the grain boundary phase, and characteristics of each sample. Notably, the group 4 element present in each sample (except for sample 9) originated from balls made of YSZ employed in the production step. All the samples 1 to 9, each having an average value of the ratio Re/(A+Re) at the grain boundary between two of the silicon nitride-based grains within a range of 0.1 to 0.5, exhibited a thermal conductivity of 85 W/mK or higher and a flexural strength of 700 MPa or higher, indicating both high thermal conductivity and flexural strength.

Samples 10 and 11 exhibited a low flexural strength. A conceivable reason is that an average of the ratio Re/(A+Re) at the grain boundary between two of the silicon nitride-based grains is less than 0.1. Since samples 10 and 11 were prepared through firing by use of a SiC-made or hBN-made mold, the reducing atmosphere during firing was impaired. Therefore, volatilization of the alkali/alkaline earth metal element was impeded, to thereby reduce the average of the ratio Re/(A+Re). It is considered that, when volatilization of the alkali/alkaline earth metal element decreases, columnar growth of the silicon nitride-based grains is not promoted and the grains grow isotropically, resulting in a drop in mechanical strength.

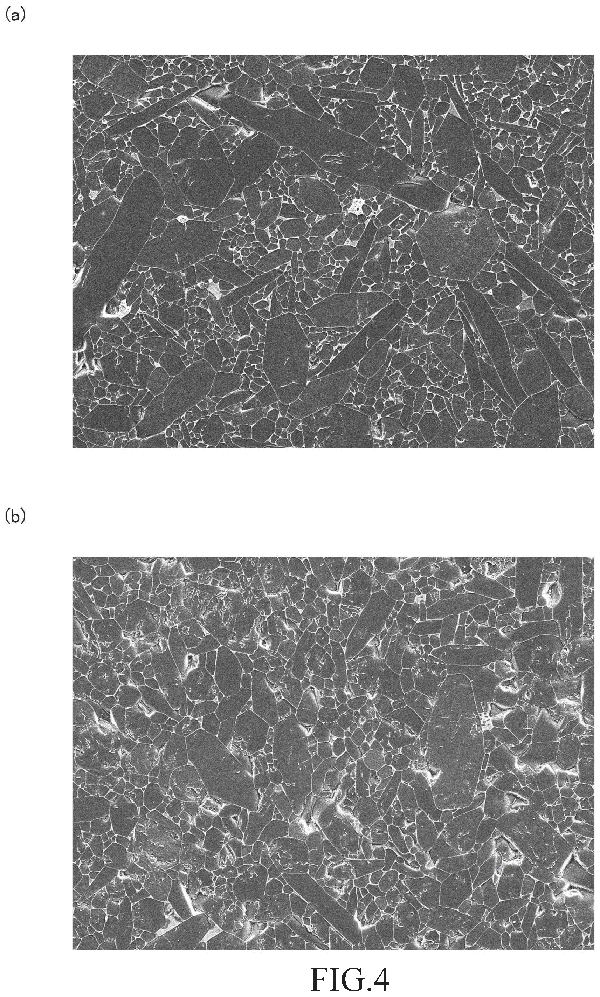

FIGs. 4(a) and 4(b) are SEM images of silicon nitride-based sintered bodies of samples 1 and 10, respectively. FIGs. 4(a) and 4(b) show SEM images at a magnification of × 2,000 of polished and plasma-etched surfaces of the respective samples. As shown in FIG. 4(a), silicon nitride-based grains were grown in a columnar manner in various directions. In contrast, as shown in FIG. 4(b), no columnar growth of silicon nitride-based grains was observed.

Based on the comparison between sample 2 and sample 8, regarding the group 4 element compound included in the silicon nitride-based sintered body, a compound containing a group 4 element and nitrogen and a compound containing a group 4 element, nitrogen, and carbon were found to play a common role. Furthermore, a compound containing a group 4 element and carbon may be conceivably acceptable as the group 4 element compound.

Sample 9 exhibited a slightly low thermal conductivity and a slightly low flexural strength. A conceivable reason is that a group 4 element compound is not incorporated into the silicon nitride-based sintered body. Thus, incorporation of the group 4 element compound into the silicon nitride-based sintered body was found to be preferable. In contrast, sample 9 exhibited a flexural strength higher than that of sample 10 or 11. In other words, even in the case of a silicon nitride-based sintered body containing no group 4 element compound, when the average of the ratio Re/(A+Re) at the grain boundary between two of the silicon nitride-based grains was 0.1 to 0.5, a higher flexural strength was found to be achieved, as compared with the case in which the average of the ratio Re/(A+Re) was lower than the lower limit of the range.

From the above-described test results, it is confirmed that the silicon nitride-based sintered body and the silicon nitride-based heat radiation substrate of the present invention can achieve higher mechanical strength while maintaining high thermal conductivity by controlling the firing conditions such that the average of the ratio Re/(A+Re) at the grain boundary between two of the silicon nitride-based grains falls within a range of 0.1 to 0.5 in the silicon nitride-based sintered body in which a rare earth element content and an alkali/alkaline earth metal element content are within predetermined ranges, respectively.

Needless to say, the present invention is not limited to the above-described embodiments and encompasses various modifications and equivalents included in the idea and scope of the present invention. In addition, the structures, shapes, numbers, positions, sizes, etc. of the constituent elements shown in the drawings are for the convenience of description and may be changed as appropriate.

### DESCRIPTION OF REFERENCE NUMERALS

10: silicon nitride-based heat radiation substrate
12: circuit layer
14: conductor layer
20: circuit substrate
22: solder
30: power semiconductor
40: heat radiation plate
42: grease
50: heat radiation member
100: power device

## Claims

1. A silicon nitride-based sintered body mainly comprising silicon nitride-based grains and a grain boundary phase surrounding the silicon nitride-based grains, wherein
the silicon nitride-based sintered body at least contains a rare earth element in a total amount of 1.0 to 6.5 wt% and an alkali/alkaline earth metal element in a total amount of 0.3 to 3.0 wt%, and
an average value of element ratio Re/(A+Re) at the grain boundary between two of the silicon nitride-based grains is 0.1 to 0.5, wherein Re represents an element amount of the rare earth element, and A represents an element amount of the alkali/alkaline earth metal element.

2. The silicon nitride-based sintered body according to claim 1, wherein
the alkali/alkaline earth metal element contains one or more elements selected from Mg and Ca, and
the rare earth element contains one or more elements selected from Y, La, and Yb.

3. The silicon nitride-based sintered body according to claim 1 or 2, wherein
the silicon nitride-based sintered body further contains a group 4 element, and
at least a part of the group 4 element forms one or more compounds each containing nitrogen or carbon.

4. A silicon nitride-based heat radiation substrate, **characterized by** being formed of the silicon nitride-based sintered body according to claim 1 or 2.

5. The silicon nitride-based heat radiation substrate according to claim 4, wherein
the substrate has a flexural strength of 700 MPa or higher.

6. The silicon nitride-based heat radiation substrate according to claim 4, wherein
the substrate has a thermal conductivity of 85 W/mK or higher.

7. The silicon nitride-based heat radiation substrate according to claim 4, wherein
the substrate has a thickness in a direction perpendicular to its one main face of 220 µm or more and 690 µm or less.
